# EUROPEAN PATENT APPLICATION

(11) **EP 2 650 916 A2**
(43) Date of publication of application: **16.10.2013**
(21) Application number: 13162936.2
(22) Date of filing: 09.04.2013
(51) Int. Cl.: H01L 23/498

(54) **Substrate device**

(30) Priority: 09.04.2012 JP 2012088347
(71) Applicant: Yokogawa Electric Corporation, Tokyo 180-8750 (JP)
(72) Inventor: Hiwatashi, Masaya, Tokyo Tokyo 180-8750 (JP)
(74) Representative: Zimmermann, Tankred Klaus

(57) **Abstract**

A substrate device, includes: a plurality of substrates stacked one on another including a substrate (10) on which electronic components (12a to 12d) are mounted; and a coupling member (30 and 40) connecting mechanically and electrically the two opposed substrates (10 and 20), wherein the coupling member includes: a plurality of core-less solder balls (40) connecting mechanically and electrically the two opposed substrates (10 and 20); and a plurality of spacers (30) configured to keep a clearance between the two opposed substrates (10 and 20) wider than a mounting height of the electronic component (12d) between the substrates.

## Description

### CROSS-REFERENCE TO RELATED APPLICATION

This application claims priority from Japanese Patent Application No. 2012-088347 filed with the Japan Patent Office on April 9, 2012, the entire content of which is hereby incorporated by reference.

### BACKGROUND

### 1. Technical Field

The disclosure herein relates to a substrate device.

### 2. Related Art

In general, electronic equipment has a substrate device to realize downsizing and power saving of the equipment. The substrate device has a plurality of substrates stacked one on another and includes a printed board on which electronic components are mounted. The substrate device has two opposed substrates that are mechanically and electrically connected to each other via solder balls. This enhances package density of the substrates.

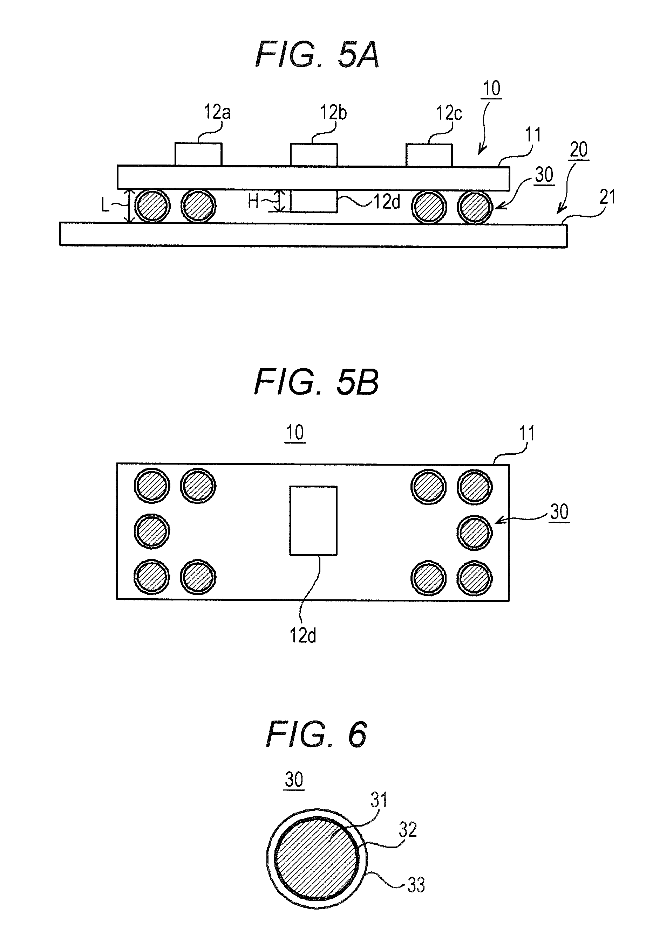

Figs. 5A and 5B are explanatory diagram illustrating the configuration of an exemplary substrate device used in conventional electronic equipment. Fig. 5A is a side view of the substrate device. Fig. 5B is a plane view of a surface of an upper first substrate 10 opposite to resin core solder balls 30. As depicted in Figs. 5A and 5B, the conventional substrate device has the first substrate 10 as an upper module substrate and a second substrate 20 as a lower mother substrate that are mechanically and electrically connected via the resin core solder balls 30.

As depicted in Figs. 5A and 5B, the first substrate 10 has a printed board 11. The printed board 11 has a plurality of electronic components 12a to 12d mounted on the opposite surfaces thereof. That is, the first substrate 10 is a module substrate with a predetermined signal processing function. The printed board 11 has the plurality of resin core solder balls 30 on a surface opposite to the second substrate 20 (back surface).

Fig. 6 is a cross section view of a specific example of the resin core solder ball 30. The resin core solder ball 30 has a ball-shaped resin core 31. The surface of the resin core 31 is covered with a solder film 33 via a conductive film 32 containing copper, for example. For example, the resin core solder ball 30 may be Micropearl SOL (trade name) manufactured by Sekisui Chemical Co., Ltd.

As depicted in Fig. 5A, a diameter L of the resin core solder balls 30 is larger than a mounting height H of an electronic component 12d on the printed board 11 (L > H). Therefore, when the upper first substrate 10 is stacked on the lower second substrate 20 and these substrates are coupled and connected via the resin core solder balls 30, the electronic component 12d mounted on the printed board 11 can be prevented from contacting the opposite surface of the lower second substrate 20.

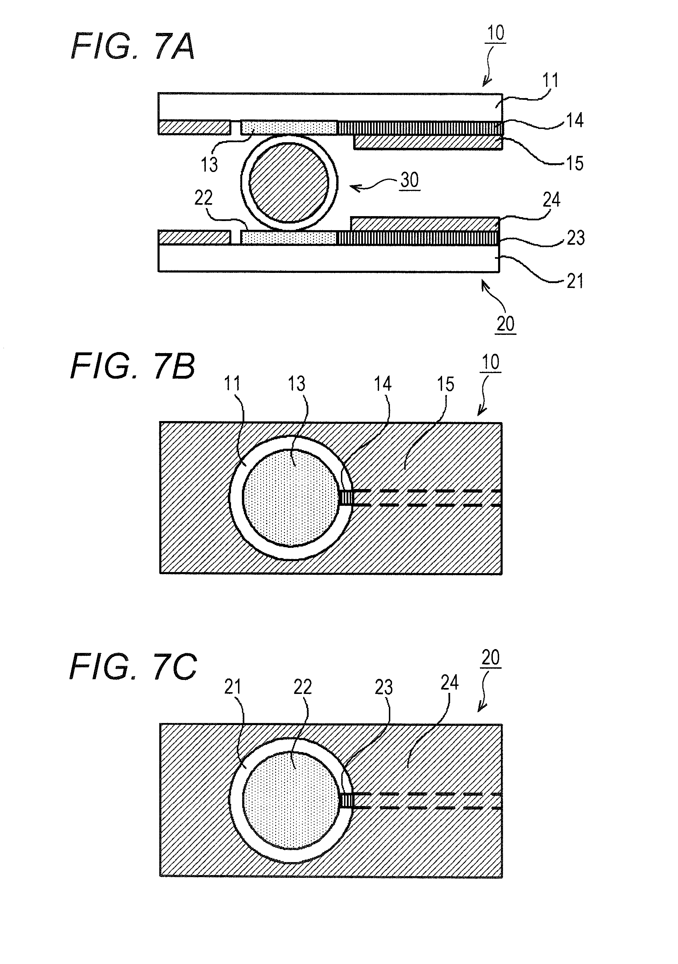

Figs. 7A to 7C are enlarged schematic views of a coupling portion via the resin core solder balls 30 depicted in Fig. 5A. Fig. 7A is a cross section view. Fig. 7B is a plane view of a surface of the upper first substrate 10 opposite to the resin core solder ball 30. Fig. 7C is a plane view of a surface of the lower second substrate 20 opposite to the resin core solder ball 30.

As depicted in Fig. 7B, the first substrate 10 has the printed board 11. A land pattern 13 is formed on the surface of the first substrate 10 opposite to the resin core solder ball 30. Solder in the resin core solder ball 30 is melted and fixed to the land pattern 13. Further, a wiring pattern 14 is formed on the opposite surface of the first substrate 10. The land pattern 13 is connected to an end of the wiring pattern 14. In addition, a solder resist 15 is formed on the opposite surface of the first substrate 10 such that the land pattern 13 and surrounding parts are exposed.

Similarly, as depicted in Fig. 7C, the second substrate 20 has a printed board 21. A land pattern 22 is formed on a surface of the second substrate 20 opposite to the resin core solder ball 30. Solder in the resin core solder ball 30 is melted and fixed to the land pattern 22. Further, a wiring pattern 23 is formed on the opposite surface of the second substrate 20. The land pattern 22 is connected to an end of the wiring pattern 23. A solder resist 24 is formed on the surface of the wiring pattern 23 such that the land pattern 22 and surrounding parts are exposed.

JP-A-2004-241594 discloses a technique for a semiconductor package using resin core solder balls.

### SUMMARY

A substrate device includes: a plurality of substrates stacked one on another including a substrate on which electronic components are mounted; and a coupling member connecting mechanically and electrically the two opposed substrates, and the coupling member includes: a plurality of core-less solder balls connecting mechanically and electrically the two opposed substrates; and a plurality of spacers configured to keep a clearance between the two opposed substrates wider than a mounting height of the electronic component between the substrates.

According to the substrate device, the connection state of the substrates in a mechanically and electrically stable manner can be maintained even if warpage occurs in the substrates by heating. Further, the substrate device makes it possible to obtain a self-alignment effect due to the surface tension of melted solder and a high substrate holding strength.

### BRIEF DESCRIPTION OF DRAWINGS

Figs. 1A and 1B are illustration diagrams depicting a configuration of a substrate device according to one embodiment of the disclosure herein;
Figs. 2A to 2C are enlarged schematic views of a coupling portion via resin core solder balls in the substrate device depicted in Fig. 1;
Figs. 3A to 3C are other enlarged schematic views of a coupling portion via resin core solder balls in the substrate device depicted in Fig. 1;
Figs. 4A and 4B are illustration diagrams of warpage occurring in a first substrate in the substrate device depicted in Fig. 1;
Fig. 5A is a cross section view of a conventional substrate device;
Fig. 5B is a plane view of the conventional substrate device;
Fig. 6 is a cross section view of a specific example of a resin core solder ball;
Figs. 7A to 7C are enlarged schematic views of a coupling portion via resin core solder balls in the substrate device depicted in Fig. 5; and
Figs. 8A and 8B are illustration diagrams of warpage occurring in a first substrate in the substrate device depicted in Fig. 5.

### DETAILED DESCRIPTION

In the following detailed description, for purpose of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

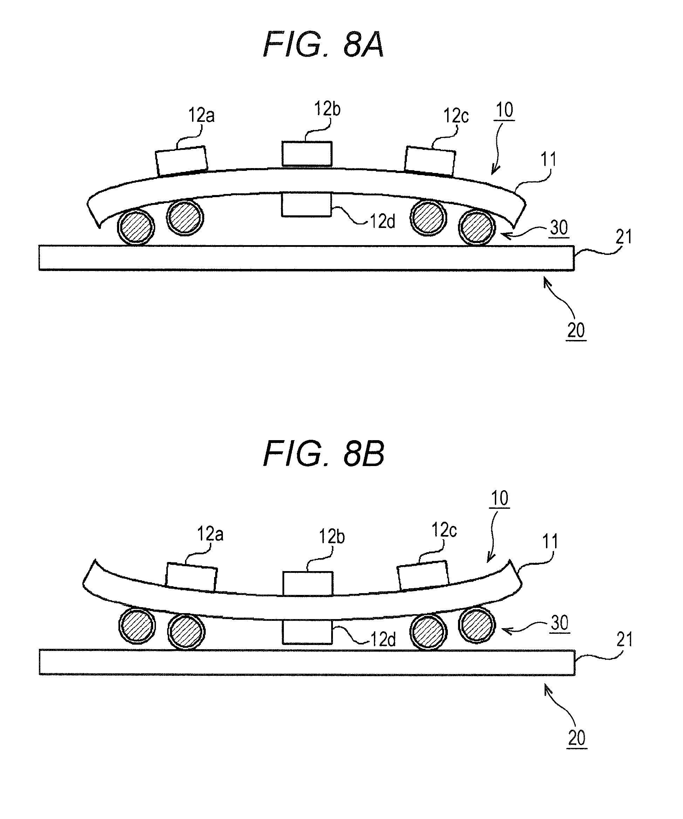

In the foregoing conventional example, the first substrate 10 and the second substrate 20 are stacked one on another and connected mechanically and electrically via the resin core solder balls 30. For example, first, the first substrate 10 and the second substrate 20 are stacked via the resin core solder balls 30. The thus obtained stacked body is heated in a reflow furnace. It is known that, during the heating, warpage occurs at least in either of the first substrate 10 and the second substrate 20 as depicted in Figs. 8A and 8B. That is, the first substrate 10 and the second substrate 20 contain a conductor (metal) and an insulator (resin). The conductor (metal) and the insulator (resin) are different in coefficient of thermal expansion. During the heating, therefore, the first substrate 10 and/or the second substrate 20 change in shape.

The amount of solder in the resin core solder balls 30 is significantly small as compared to other conventional solder balls.

As a result, the resin core solder balls 30 exert a weak force for controlling warpage in the first substrate 10 and the second substrate 20. Thus, connection failure may occur when a distance between the first substrate 10 and the second substrate 20 is larger.

In addition, the use of the resin core solder balls 30 may decrease a self-alignment effect. The self-alignment effect refers to a phenomenon that, during reflow heating, components mounted on the surface of a substrate are pulled to the center of a land pattern on the substrate due to the surface tension of solder.

Further, the substrates may be subjected to reflow heating in a state where the second substrate 20 is positioned on the upper side and the first substrate 10 is positioned on the lower side. In this state, since the resin core solder balls 30 exert a small force for holding the substrates, the first substrate 10 may fall off from the second substrate 20.

One object of the disclosure herein is to provide a substrate device capable of maintaining the connection state of substrates in a mechanically and electrically manner even if warpage occurs in the substrates. Another object of the disclosure herein is to provide a substrate device capable of obtaining a self-alignment effect due to the surface tension of melted solder and a high substrate holding strength.

A substrate device (subject device) according to this embodiment includes: a plurality of substrates stacked one on another including a substrate on which electronic components are mounted; and a coupling member connecting mechanically and electrically the two opposed substrates, and the coupling member includes: a plurality of core-less solder balls connecting mechanically and electrically the two opposed substrates; and a plurality of spacers configured to keep a clearance between the two opposed substrates wider than a mounting height of the electronic component between the substrates.

The spacers may be resin core solder balls or copper core solder balls.

The spacers may include a stud with an end surface fixed to the substrate via an adhesive member.

The two opposed substrates may include a module substrate on which electronic components are mounted and a mother substrate.

The substrates may be semiconductor bear chips, and the electronic components may include a semiconductor.

The subject device can maintain the connection state of substrates in a mechanically and electrically manner even if warpage occurs in the substrates due to heating. Further, the subject device makes it possible to obtain a self-alignment effect due to the surface tension of melted solder and a high substrate holding strength.

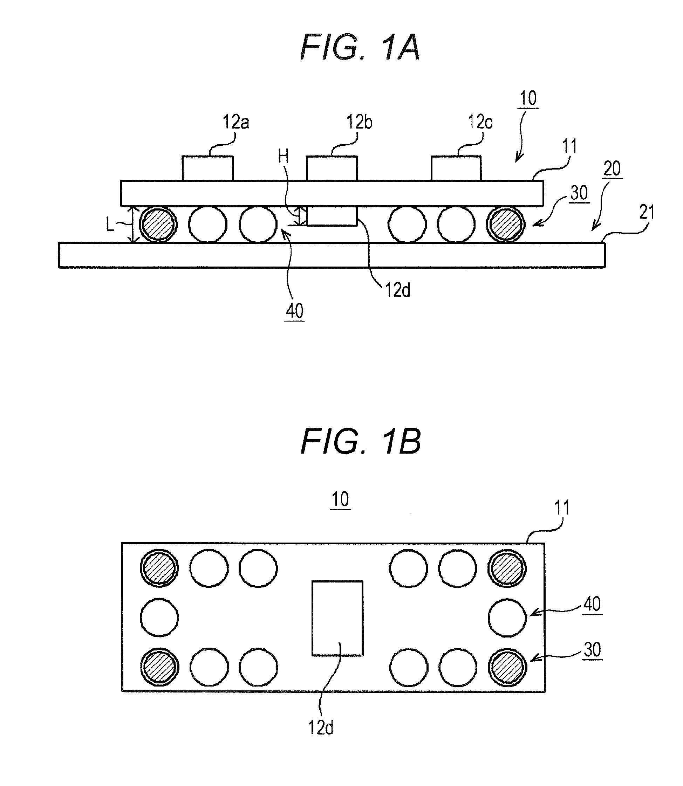

An embodiment of the disclosure herein will be described below in detail with reference to the drawings. Figs. 1A and 1B are illustration diagrams depicting a configuration of a substrate device (subject device) according to one embodiment of the disclosure herein.

First, differences between the subject device and the conventional substrate device depicted in Fig. 5A and others will be described. In the subject device, a plurality of (two) substrates is mechanically and electrically connected to each other by not only resin core solder balls but also core-less solder balls.

Further, in the subject device, resin core solder balls with a predetermined height are arranged between the substrates. The resin core solder balls function as spacers. The resin core solder balls (spacers) keep a clearance between the plurality of (two) substrates larger than a mounting height of the mounted electronic components.

Meanwhile, in the example depicted in Fig. 5, the two substrates are mechanically and electrically connected to each other only via resin core solder balls.

As depicted in Fig. 1A, the subject device includes the first substrate 10 as a module substrate and the second substrate 20 as a mother substrate. The first substrate 10 includes a printed board 11 and a plurality of electronic components 12a to 12d mounted on the opposite surfaces of the printed board 11. That is, the first substrate 10 is a module substrate with a predetermined signal processing function.

As depicted in Fig. 1B, a plurality of resin core solder balls 30 with a structure as depicted in Fig. 6 is mounted in the vicinity of four corners on a surface (back surface) of the printed board 11 opposite to the second substrate 20. Further, a plurality of core-less solder balls 40 is discretely mounted between the plurality of resin core solder balls 30 along the four sides of the first substrate 10. Amount of solder in the core-less solder balls 40 is sufficiently large as compared with the resin core solder balls 30.

A diameter L of these resin core solder balls 30 and core-less solder balls 40 is larger than a mounting height H of the electronic component 12d on the printed board 11 (L > H). Therefore, when the upper first substrate 10 and the lower second substrate 20 stacked on each other are connected via the resin core solder balls 30 and the core-less solder balls 40, the electronic component 12d mounted on the printed board 11 can be prevented from contacting the opposite surface of the lower second substrate 20.

These resin core solder balls 30 and core-less solder balls 40 function as described below.

When the upper first substrate 10 is stacked on the lower second substrate 20, the resin core solder balls 30 function as spacers. Specifically, the resin core solder balls 30 ensure a clearance L between the first substrate 10 and the second substrate 20 to prevent the electronic component 12d mounted on the printed board 11 from contacting the opposite surface of the lower second substrate 20. The resin core solder balls 30 are not used as a connection member that connects mechanically and electrically the upper first substrate 10 and the lower second substrate 20 by reflow heating.

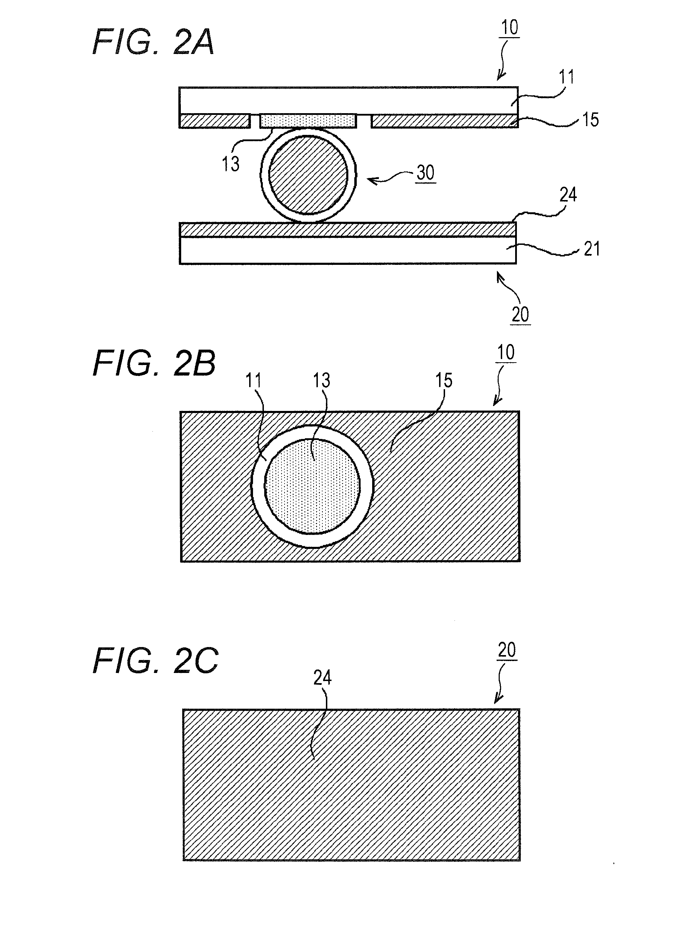

Figs. 2A to 2C are enlarged views of a coupling portion via the resin core solder balls 30 in the subject device depicted in Figs. 1A and 1B. Fig. 2A is a cross section view. Fig. 2B is a plane view of the surface of the upper first substrate 10 opposite to the resin core solder balls 30. Fig. 2C is a plane view of the surface of the lower second substrate 20 opposite to the resin core solder balls 30.

As depicted in Fig. 2B, the first substrate 10 has the printed board 11. A land pattern 13 is formed on the surface of the first substrate 10 opposite to the resin core solder balls 30. Solder in the resin core solder balls 30 is melted and fixed to the land pattern 13. The land pattern 13 is not connected to an end of a wiring pattern as depicted in Fig. 7B. Further, a solder resist 15 is formed on the opposite surface of the first substrate 10 such that the land pattern 13 and surrounding parts are exposed.

As depicted in Fig. 2C, the second substrate 20 has the printed board 21. A solder resist 24 is formed on almost the entire surface of the second substrate 20 opposite to the resin core solder balls 30. The second substrate 20 has no land pattern where solder in the resin core solder balls 30 is melted and fixed is formed, on the opposite surface thereof.

Hence, the resin core solder balls 30 depicted in Fig. 2A are fixed by solder to the land pattern 13 on the first substrate 10, but are not fixed to the second substrate 20. Therefore, the resin core solder balls 30 do not contribute to an electrical and mechanical connection between the first substrate 10 and the second substrate 20. The resin core solder balls 30 function as spacers between the first substrate 10 and second substrate 20.

The resin core solder balls 30 provide the predetermined clearance L between the first substrate 10 and the second substrate 20. The clearance L is sized to prevent the electronic component 12d mounted on the printed board 11 from contacting the opposite surface of the lower second substrate 20.

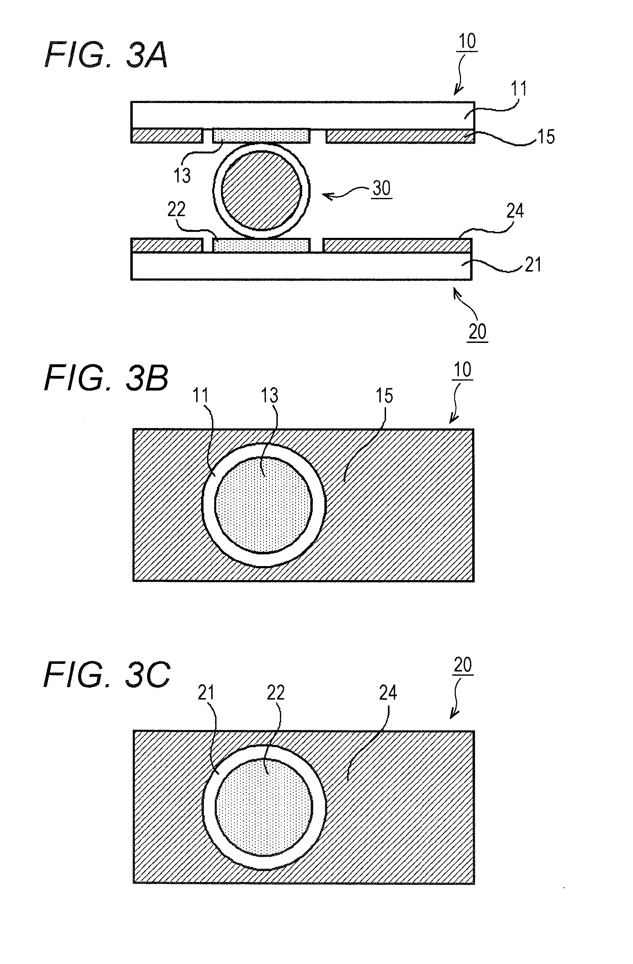

Figs. 3A to 3C are other enlarged schematic views of the part coupled by the resin core solder balls 30 in the subject device depicted in Fig. 1. Fig. 3A is a cross section view. Fig. 3B is a plane view of the surface of the upper first substrate 10 opposite to the resin core solder balls 30. Fig. 3C is a plane view of the surface of the lower second substrate 20 opposite to the resin core solder balls 30.

As depicted in Fig. 3B, the first substrate 10 has the printed board 11. The land pattern 13 is formed on the surface of the first substrate 10 opposite to the resin core solder balls 30, as on the first substrate 20 depicted in Fig. 2B. Solder in the resin core solder balls 30 is melted and fixed to the land pattern 13. The land pattern 13 is not connected to an end of a wiring pattern as depicted in Fig. 7B. Further, the solder resist 15 is formed on the opposite surface of the first substrate 10 such that the land pattern 13 and surrounding parts are exposed.

As depicted in Fig. 3C, the second substrate 20 has the printed board 21. The land pattern 22 is formed on the surface of the second substrate 20 opposite to the resin core solder balls 30, as on the first substrate 10 depicted in Fig. 2B. Solder in the resin core solder balls 30 is melted and fixed to the land pattern 22. The land pattern 22 is not connected to an end of a wiring pattern as depicted in Fig. 7C. The solder resist 24 is formed on the opposite surface of the second substrate 20 such that the land pattern 22 and surrounding parts are exposed.

Hence, the resin core solder balls 30 depicted in Fig. 3A are fixed by solder to the land pattern 13 on the first substrate 10 and the land pattern 22 on the second substrate 20. Meanwhile, these land pattern 13 and land pattern 22 are not connected to ends of wiring patterns. Therefore, the land patterns 13 and 22 do not contribute to the electrical connection between the first substrate 10 and the second substrate 20 or the electric connection between electronic components connected to ends of wiring patterns.

Thus, the resin core solder balls 30 function as spacers between the first substrate 10 and the second substrate 20, and also function as a mechanical connecting (coupling) member. Specifically, the resin core solder balls 30 provide the clearance L with a predetermined size (height) between the first substrate 10 and the second substrate 20. Thus, the electronic component 12d mounted on the printed board 11 can be prevented from contacting the opposite surface of the lower second substrate 20.

The core-less solder balls 40 depicted in Fig. 1A has the following functions:
1) The core-less solder balls 40 are subjected to reflow heating to connect mechanically and electrically the upper first substrate 10 and the lower second substrate 20.
2) The core-less solder balls 40 lead to a self-alignment effect. The self-alignment effect refers to a phenomenon that components mounted on the surface of a substrate are pulled to the center of a land pattern on the substrate due to the surface tension of melted solder during reflow heating.
3) The core-less solder balls may be subjected to reflow heating in a state where the second substrate 20 is positioned on the upper side and the first substrate 10 is positioned on the lower side. In this state, the core-less solder balls 40 provide the subject device with a substrate holding force enough to prevent the first substrate 10 from falling off from the second substrate 20.

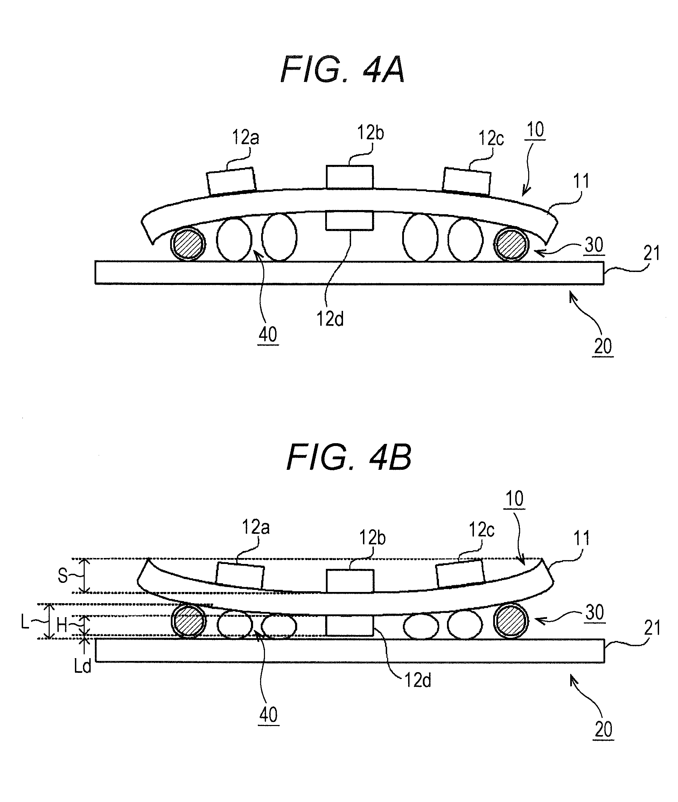

As depicted in Fig. 1A, the first substrate 10 and the second substrate 20 are stacked via the resin core solder balls 30 and the core-less solder balls 40. The thus obtained stacked body is subjected to reflow heating, thereby obtaining the subject device. Figs. 4A to 4C are diagrams depicting warpage in the first substrate 10 occurring at the reflow heating. Fig. 4A depicts the case where warpage occurs in the first substrate 10 such that both ends thereof come closer to the second substrate 20. Fig. 4B depicts the case where warpage occurs in the first substrate 10 such that the both ends thereof go away from the second substrate 20.

The first substrate 10 and the second substrate 20 contain a conductor (metal) and an insulator (resin). The conductor (metal) and the insulator (resin) are different in coefficient of thermal expansion. Therefore, it is conceived that the foregoing warpage occurs due to shape changes in the first substrate 10 during heated.

As depicted in Fig. 4A, electronic components 12b and 12d are mounted at the central part of the first substrate 10. The first substrate 10 may be warped such that the both ends thereof come closer to the second substrate 20. In this case, the clearance extends between the central part of the first substrate 10 and the second substrate 20. In this arrangement, the amount of solder in the core-less solder balls 40 is sufficiently large as compared to the amount of solder in the resin core solder balls 30. Thus, the core-less solder balls 40 can be stretched and vertically deformed according to the extension of the clearance between the central part of the first substrate 10 and the second substrate 20. Therefore, the mechanical and electrical connection between the first substrate 10 and the second substrate 20 can be maintained by the core-less solder balls 40. As a result, a stable mechanical and electrical connection between the first substrate 10 and the second substrate 20 can be ensured.

In addition, as depicted in Fig. 4B, the first substrate 10 may be warped such that the both ends thereof go away from the second substrate 20. In this case, the clearance shrinks between the central part of the first substrate 10 and the second substrate 20. The core-less solder balls 40 are crushed and laterally deformed according to the shrinkage of the clearance between the central part of the first substrate 10 and the second substrate 20.

The resin core solder balls 30 functioning as spacers are mounted in the vicinities of the both ends of the first substrate 10. Specifically, the resin core solder balls 30 provide the clearance L between the first substrate 10 and the second substrate 20 to avoid the electronic component 12d mounted on the printed board 11 from contacting the opposite surface of the lower second substrate 20. Therefore, a clearance Ld between the electronic component 12d and the opposite surface of the lower second substrate 20 is determined as depicted in Fig. 4B:
Ld = the diameter L of the resin core solder balls 30 - warpage S in the first substrate 10 - the mounting height H of the electronic component 12d

Therefore, when the diameter L of the resin core solder balls 30 is selected as appropriate with respect to the mounting height H of the electronic component 12d and the warpage S in the first substrate 10, the clearance Ld is larger than 0. Therefore, the electronic component 12d can be prevented from contacting the opposite surface of the second substrate 20.

As in the foregoing, at manufacture of the subject device, the first substrate 10 and the second substrate 20 are stacked and mechanically and electrically connected via the coupling member. In the subject device, the resin core solder balls 30 and the core-less solder balls 40 are used in combination as the coupling member. Thus, even if warpage occurs at least in either of the stacked first substrate 10 and second substrate 20 resulting from reflow heating, the connection state of the first substrate 10 and the second substrate 20 in the subject device can be maintained in a mechanically and electrically stable manner. Further, in the subject device, the coupling member includes the core-less solder balls 40. Therefore, the device can be provided with a self-alignment effect due to the surface tension of melted solder and also provided with a high substrate holding strength of the core-less solder balls 40.

In this embodiment, the coupling member includes the resin core solder balls 30. In this regard, the coupling member in the subject device may include other core solder balls. Specifically, the coupling member in the subject device may include copper core solder balls. Further, the coupling member may include both the resin core solder balls and the copper core solder balls.

These core solder balls are used to provide a clearance between substrates. Thus, the coupling member may include, instead of the core solder balls, studs (spacers) that have end surfaces fixed by an adhesive member (solder, adhesive agent, or the like) to the substrates. The coupling member may include both the core solder balls and the studs.

In the embodiment, the resin core solder balls 30 are provided on the first substrate 10 near four corners. Further, the core-less solder balls 40 are discretely provided between the resin core solder balls 30 along the four sides of the first substrate 10. In this regard, the resin core solder balls 30 may be provided at any other parts not requiring electrical connection between the substrates. In addition, the number of the resin core solder balls 30 is not limited to four. Further, the number of the core-less solder balls 40 may be increased or decreased depending on the intended use.

The first substrate 10 is not limited to a module substrate. For example, the first substrate 10 may be a semiconductor package substrate as far as the first substrate 10 includes a printed board.

Similarly, the second substrate 20 is not limited to a mother board. The second substrate 20 may be any other board as far as the second substrate 20 includes a printed board.

Material for the first substrate 10 and the second substrate 20 may be FR4 or ceramic. The layer structure of the first substrate 10 and the second substrate 20 is not limited to the structure disclosed in relation to the embodiment. In addition, the method for producing the first substrate 10 and the second substrate 20 may be any method including a semi-additive method or a full-additive method.

The first substrate 10 and the second substrate 20 may be semiconductor bear chips.

In the embodiment, the two substrates (the first substrate 10 and the second substrate 20) are stacked. The subject device may include three or more substrates stacked one on another. Further, the subject device may include multi-substrates stacked one on another.

In the subject device, the substrate on which the electronic components are mounted is not limited to the first substrate 10. The substrate on which the electronic components are mounted may be the second substrate 20 or both the first substrate 10 and the second substrate 20. In addition, the number and the mounting positions of the electronic components are not limited to the number and positions disclosed in relation to the embodiment but may be changed as appropriate.

The electronic components in the subject device may include semiconductors or members other than semiconductors.

As in the foregoing, the subject device includes a plurality of substrates stacked one on another including a substrate on which electronic components are mounted. The two opposed substrates are mechanically and electrically connected via the coupling member. In the subject device, the coupling member includes the spacers (the resin core solder balls 30) and the core-less solder balls 40. Thus, even if warpage occurs in the substrate resulting from reflow heating, the connection state of the first substrate 10 and the second substrate 20 can be obtained in a mechanically and electrically stable manner. Further, it is also possible to obtain a self-alignment effect on the electronic components due to the surface tension of melted solder and a high substrate holding strength of the core-less solder balls 40.

The substrate device in the embodiment may be any of the following first to fifth substrate devices. The first substrate device is configured such that a plurality of substrates including a substrate on which electronic components are mounted is stacked, the substrates are mechanically coupled and electrically connected via a coupling member between the substrates, wherein the coupling member uses in combination a plurality of core-less solder balls connecting mechanically and electrically the substrates and a plurality of spacers with a height with which it is possible to provide a wider clearance between the substrates than an mounting height of the electronic components mounted between the substrates.

The second substrate device is configured such that the plurality of spacers in the first substrate device is replaced by resin core solder balls or copper core solder balls. The third substrate device is configured such that the plurality of spacers in the first or second substrate device is replaced by studs fixed at end surfaces to the opposed substrate.

The fourth substrate device is configured such that, in any of the first to third substrate devices, one of the substrates stacked one on another is a module substrate on which electronic components are mounted, and the other substrate is a mother substrate. The fifth substrate device is configured such that, in any of the first to third substrate device, the substrates stacked one on another are semiconductor bear chips and the electronic components are semiconductors.

In the first to fifth substrate devices, when the plurality of substrates including a substrate with components mounted is stacked, and mechanically coupled and electrically connected via the coupling member between the substrates, even if warpage occurs in the substrates that are stacked on one another, and coupled and connected to each other (stacked substrates) due to heating (for example, reflow heating), it is possible to obtain a coupled and connected state in a mechanically and electrically stable manner and also obtain a self-alignment effect due to the surface tension of melted solder and a high substrate holding strength.

The foregoing detailed description has been presented for the purposes of illustration and description. Many modifications and variations are possible in light of the above teaching. It is not intended to be exhaustive or to limit the subject matter described herein to the precise form disclosed. Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims appended hereto.

## Claims

1. A substrate device, comprising:
a plurality of substrates stacked one on another including a substrate (10) on which electronic components (12a to 12d) are mounted; and
a coupling member (30 and 40) connecting mechanically and electrically the two opposed substrates (10 and 20), wherein
the coupling member includes:
a plurality of core-less solder balls (40) connecting mechanically and electrically the two opposed substrates (10 and 20); and
a plurality of spacers (30) configured to keep a clearance between the two opposed substrates (10 and 20) wider than a mounting height of the electronic component (12d) between the substrates.

2. The substrate device according to Claim 1, wherein the spacers (30) include core solder balls (30).

3. The substrate device according to Claim 2, wherein an amount of solder in the core-less solder balls (40) is larger than an amount of solder in the core solder balls (30).

4. The substrate device according to Claim 2, wherein a diameter of the core solder balls (30) is larger than the mounting height of the electronic components.

5. The substrate device according to Claim 2, wherein the core solder balls (30) include at least one of resin core solder balls and copper core solder balls.

6. The substrate device according to Claim 1 or 2, wherein the spacers include stud having end surfaces fixed by an adhesive member to the substrates.

7. The substrate device according to any of Claims 1 to 6, wherein the two opposed substrates (10 and 20) include a module substrate (10) on which electronic components (12a to 12d) are mounted and a mother substrate (20).

8. The substrate device according to any of Claims 1 to 6, wherein the substrates (10 and 20) are semiconductor bear chips and the electronic components (12a to 12d) include a semiconductor.
